# EUROPEAN PATENT SPECIFICATION

(11) **EP 2 364 074 B1**
(45) Date of publication and mention of the grant of the patent: **08.01.2020**
(21) Application number: 11155548.8
(22) Date of filing: 23.02.2011
(51) Int. Cl.: H05K 5/06, H05K 7/20

(54) **Housing of waterproof electronic device**
Gehäuse einer wasserdichten elektronischen Vorrichtung
Boîtier de dispositif électronique étanche

(30) Priority: 05.03.2010 JP 2010049210
(43) Date of publication of application: 07.09.2011
(73) Proprietor: Fuji Electric Co., Ltd., Kawasaki-shi Kanagawa (JP)
(72) Inventor: Yoshida, Toshihiro, Tokyo 141-0032 (JP)
(74) Representative: MERH-IP Matias Erny Reichl Hoffmann Patentanwälte PartG mbB

(56) References cited:
- EP-A1- 1 536 674
- JP-A- 10 190 249
- JP-A- 2007 096 194
- US-A1- 2006 096 774

## Description

### 1. Field of the Invention

The present invention relates to a structure of a waterproof housing for an electronic device to waterproof specifications for which a device such as a general-purpose inverter device is taken as an object.

### 2. Background Art

When using an electronic device such as the above-described general-purpose inverter device in an environment such as outdoors, for preventing rainwater from entering the electronic device from the outside of the device, the housing of the device (an outer shell of die-cast aluminum or molded resin) is formed with a structure having a protecting function of drip-proof or rainproof.

In this case, in a related general-purpose inverter device, to a box-like case with an opened front in which case circuit components are mounted, a front cover is fitted in watertight so as to prevent rainwater from entering from outside. As a means for providing the waterproof sealing, there is generally used a waterproof structure in which a sealing piece such as a waterproof packing or an O-ring packing is attached onto the periphery of the section at which the case and the cover are made fitted to each other (see JP-A-2008-154331, for example).
EP 1 536 674 A1 shows an outdoor-installed power conditioner device comprising an enclosure which is formed by an outer case and a lid.
JP 10 190249 A shows a box which is composed of a box body with its front surface open and a hanging cover having a L-shaped cross section for covering its upper and front surfaces,
JP 2007 096196 A shows a housing comprising an outdoor unit which includes a base covering the backside and topside of the outdoor unit and a cover covering the opening of the base.
[Patent Document 1] JP-A-2008-154331

Incidentally, when a sealing piece such as a waterproof packing (rubber packing) is attached at a section where a case and a cover are made fitted to each other as a means for providing the waterproof sealing of the housing as described above, for preventing the sealing piece from dropping, the sealing piece is bonded onto the opening of the case by manual work of using an adhesive. However, manual work of applying an adhesive and bonding a sealing piece is complicated and further require some time for waiting hardening of the applied adhesive. In addition, variation is caused in bonding performance depending on skills of workers. Furthermore, there is also a problem in that while an electronic device is used for a long term, a packing piece is deteriorated to lower a waterproof function.

The invention was made in view of the foregoing with an object of providing a waterproof structure of a waterproof housing for an electronic device which structure is improved so that rainwater from the outside is effectively prevented from entering the inside of a case with a system using no packing which system requires no sealing piece such as a packing and no complicated attaching work of bonding the sealing piece onto the opening of the case with an adhesive.

### SUMMARY OF THE INVENTION

For achieving the above object, according to the invention, in a waterproof housing for an electronic device of an assembly of a box-like case with an opened front in which case circuit components are mounted and a front cover attached to the case so as to cover the case, with the front cover fitted onto the periphery of the front opening of the case so as to prevent rainwater from entering from the outside, the case has an arched top plate, at the front of the case, a fitting stage, to which the front cover is fitted, is formed so as to protrude from the case along the periphery of the front opening of the case, and the fitting stage is to have at least one drain groove provided along the peripheral surfaces of the top plate section and both of the right and left side wall sections of the fitting stage so that the lower ends of the drain groove is opened downward at the bottom of the case (First aspect of the invention) . The drain grooves can be specifically formed with embodiments as follows.
(1) In the housing formed as described above, in each of the right and left side wall on the front side of the case, the side wall is preferably formed so that the lower part comes ahead of the upper part to thereby make the fitting stage, preferably having the drain groove provided along the peripheral surface thereof, preferably formed with the lower part coming ahead of the upper part to be made inclined forward from the vertical direction (Second aspect of the invention).
(2) The fitting stage preferably has two drain grooves provided along the outer peripheral surface thereof while being preferably aligned in two rows of outer and inner ones (Third aspect of the invention).

With the housing structure as described in the foregoing, high waterproofness can be ensured without using any sealing piece such as a packing. Namely,
(1) With the case made to have an arched top plate, most of rainwater externally poring on the housing and its splashes flow rightward and leftward along the curved surface of the arched top plate to quickly flow down along the external surface of the sidewall of the case. Moreover, even in the case when a part of the rainwater and splashes penetrate into a gap between the fitted case and front cover, the water penetrates into the gap, before entering into the inside of the case, flows down into the drain groove provided along the peripheral surface of the fitting stage to drop down along the drain groove onto the bottom side of the case to be then drained.
(2) In this case, the right and left side walls on the front side of the case are formed so that the lower part thereof comes ahead of the upper part to make the fitting stage, having the drain groove, formed with its lower part coming ahead of the upper part to be made inclined forward from the vertical direction. This makes the rainwater dropping into the drain groove come to flow downward along the side wall surface in the inclined drain groove without freely falling in the groove. Thus, free splashing of water drops into the inside of the case is inhibited to make it possible to effectively prevent water drops from entering the case.
(3) Furthermore, the fitting stage is made to have two drain grooves provided along the outer peripheral surface thereof while being aligned in two rows of outer and inner ones. This makes the drain groove arranged inside function as a backup drain groove for the outside drain groove. Thus, even in the case when an amount of rainwater, penetrating into the inside from the gap between the case and the cover, is so large that a part of the penetrating rainwater overflows the outside drain groove, the overflowed water can be made to flow down along the inside drain groove to be drained outward from the case, so that reliability of a waterproofing function is further increased.

In addition, with this waterproofing structure, the use of packing pieces and work requiring many man-hours for attaching packing pieces with the use of an adhesive like in the related housing are unnecessary to enable cost reduction. Furthermore, the problem of deterioration of a packing piece with age can be also solved. Moreover, the fitting stage having the drain grooves can be formed integrally with the case by means of a molding die of the case prepared for this purpose.

### BRIEF DESCRIPTION OF THE DRAWINGS

FIG. 1A is an exploded perspective view showing an example of the structure of a housing according to an embodiment of the invention;
FIG. 1B is an enlarged perspective view showing the section A of a case shown in FIG. 1A;
FIG. 1C is an enlarged cross sectional side view of the section A of the case shown in FIG. 1A showing a state with a front cover made fitted to the case;
FIG. 2 is an external perspective view showing the upper half of the case shown in FIG. 1A viewed from the back side;
FIG. 3 is a side view showing the upper half of the case shown in FIG. 1A;
FIG. 4 is an external perspective view showing the housing shown in FIG. 1A in a state of being laid down sideways; and
FIG. 5 is an enlarged perspective view showing the corner section in the section C of the case shown in FIG. 4

### DESCRIPTION OF THE PREFERRED EMBODIMEN

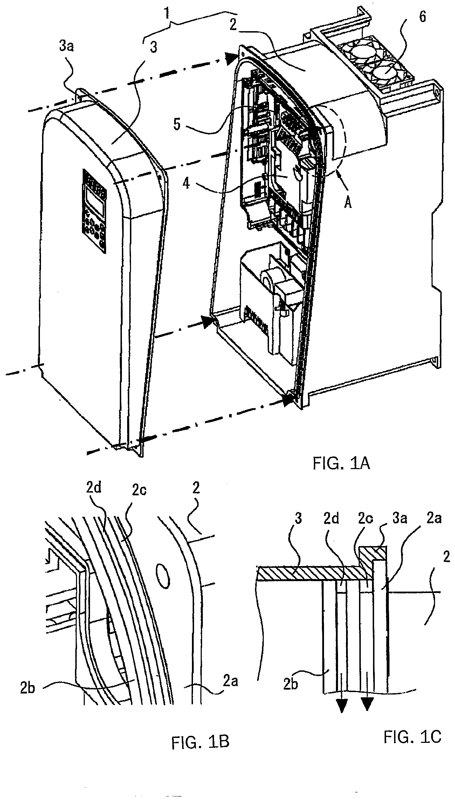

In the following, an embodiment according to the invention with a housing of a general-purpose inverter device taken as a subject will be explained on the basis of an example shown in FIG. 1A to FIG. 5.

FIGURE 1A is an exploded perspective view showing an example of the structure of a housing according to an embodiment of the invention, FIG. 1B is an enlarged view of the section A of a case shown in FIG. 1A and FIG. 1C is an enlarged cross sectional side view of the section A of the case shown in FIG. 1A showing a state with a front cover made fitted to the case;

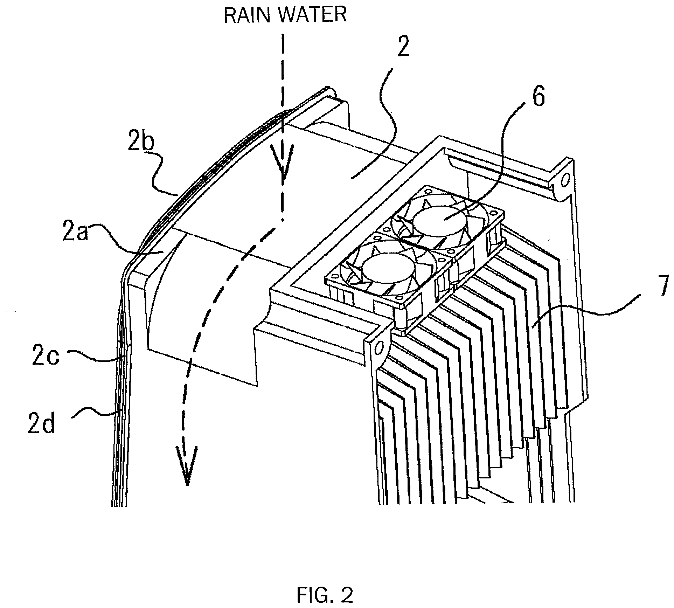

First, in FIG. 1A, reference numeral 1 denotes a housing (outer shell) of a general-purpose inverter device. The housing 1 is separately formed of a case 2 of an opened front type containing circuit parts of the inverter device and a front cover 3 made fitted to the front opening of the case 2. Both of the case 2 and front cover 3 are made of die-cast aluminum or molded resin. Moreover, inside the case 2, there are mounted a power switching device (IGBT) 4 of an inverter device and a printed circuit board 5 of a control circuit. Furthermore, on the backside of the case 2, cooling fans 6 are placed so as to introduce cooling air to a heat sink 7 (see FIG. 2) for the power switching device 4.

Here, the case 2 has an arched top plate. Moreover, at each of the four corners of the front opening of the case 2, a flange 2a is provided on which each of peripheral flanges 3a, provided on the front cover 3 at positions corresponding to the positions of the flange 2a of the case 2, is placed so as to be secured to the flange 2a by means of a tightening screw.

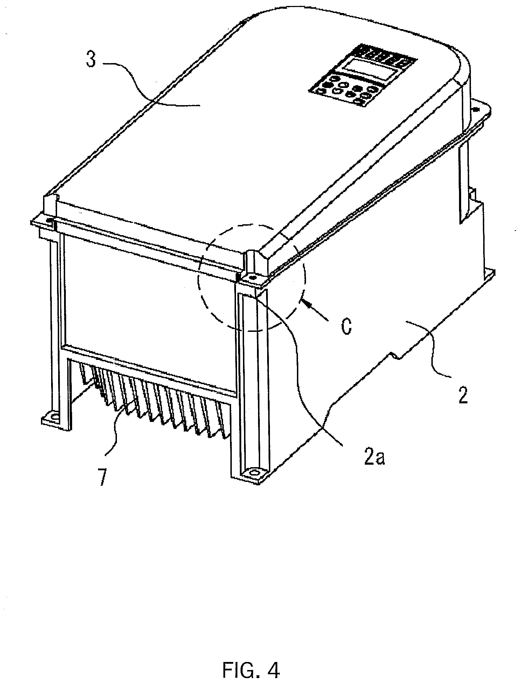

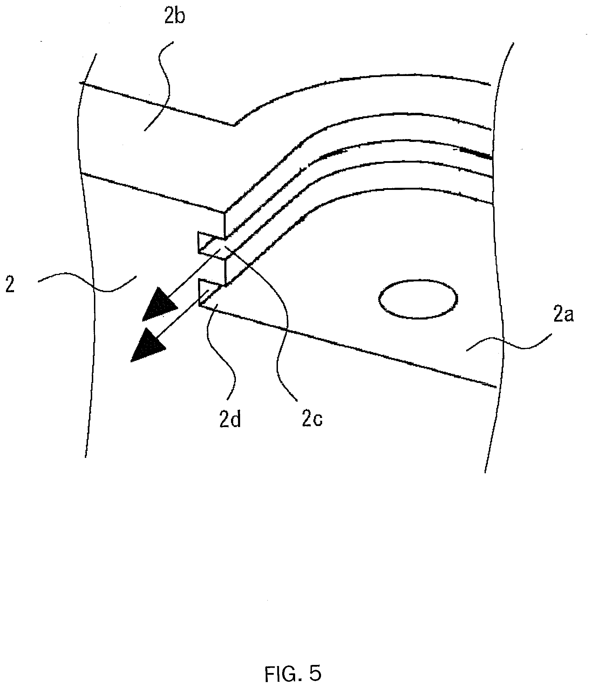

At the front of the case 2, a fitting stage 2b, to which the front cover 3 is fitted, is formed so as to protrude from the case 2 along the periphery of the front opening of the case 2. The fitting stage 2b has drain grooves 2c and 2d which are provided along the outer peripheral surface of the fitting stage 2b in the top plate section and both of the side wall sections of the case 2 while being aligned in two rows of outer and inner ones. The drain grooves 2c and 2d have their respective lower ends opened downward at the bottom of the case 2 as shown in FIG. 4 and FIG. 5. The drain groove 2d may be used for backup.

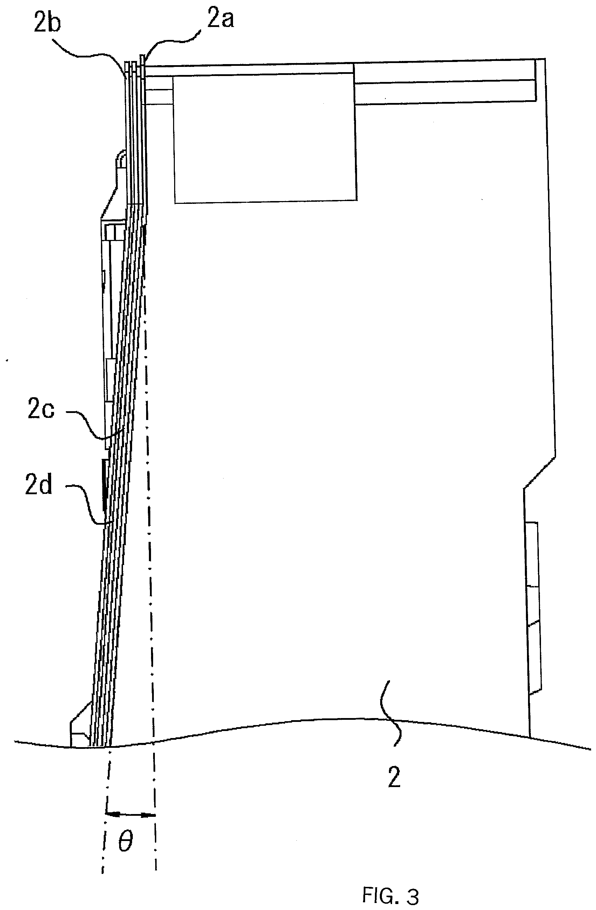

Furthermore, in each of the regions on the right and left side wall surfaces on the front side of the case 2, as shown in FIG. 3, the side wall is formed so that the lower part comes ahead of the upper part. This also makes the fitting stage 2b, having the drain grooves 2c and 2d provided along the peripheral surface thereof, formed with the lower part coming ahead of the upper part to be made a little inclined forward from the vertical direction by an angle θ.

With the structure described above, in the assembled state of the housing 1 in which the front cover 3 is made fitted to the front opening of the case 2 with the peripheral flanges 3a of the front cover 3 and the flanges 2a of the case 2 put together, the inner surface of the front cover 3 is fitted to the outer peripheral surface of the fitting stage 2b of the case 2 as shown in FIG. 1C.

This makes most of rainwater pouring on the housing 1 of an inverter device set up outdoors flow rightward and leftward along the curved surface of the arched top plate as shown by an arrow of a broken line shown in FIG. 2. The rainwater then flows downward along the surface of the sidewall of the case 2 to be drained from the case 2. Moreover, even in the case when splashes of the rainwater penetrate into a small space between the fitted case 2 and front cover 3, the penetrating splashes flow down into the drain groove 2c provided along the peripheral surface of the fitting stage 2b to flow down in the drain groove 2c as shown by an arrow shown in FIG. 1C to be drained outward from the bottom end of the drain groove 2c. In addition, in the case when an amount of the penetrating rainwater is so large that a part of the penetrating rainwater overflows the drain groove 2c of a first row to penetrate into inside, the drain groove 2d of a second row functions as a back up drain groove to let overflowed water flow down in the drain groove 2d to be drained outward, so that highly reliable waterproofness can be ensured.

Also in this case, as was explained in the foregoing with reference to FIG. 3, the drain grooves 2c and 2d provided along the side wall surfaces of the fitting stage 2b are formed to be inclined forward, by which rainwater flows down in the drain grooves 2c and 2d comes to flow down along the side wall surfaces in the drain grooves 2c and 2d without freely scattering in the grooves. This inhibits unnecessary scattering of penetrated water to make it possible to more effectively prevent the penetrated water from entering inside the case 2.

In addition, the drain groove 2d on the outside is for draining overflowed water from the drain groove 2c on the inside. However, an amount of the overflowed water is small. Therefore, the cross sectional area of the drain groove 2d is better made to be smaller than the cross sectional area of the drain groove 2c. This makes the fitting stage 2b no longer provided with a width more than necessary.

## Claims

1. A waterproof housing for an electronic device; the housing comprising an assembly of a box-like case (2) with an opened front in which case circuit components are mountable and a front cover (3) attached to the case so as to cover the case, with the front cover fitted onto the periphery of the front opening of the case (2) so as to prevent rainwater from entering from the outside,
wherein
the case (2) has an arched top plate,
at the front of the case (2), a fitting stage (2b), to which the front cover (3) is fitted, is formed so as to protrude from the case along the periphery of the front opening of the case (2), and
the fitting stage (2b) has at least one drain groove (2c, 2d) provided along the peripheral surfaces of the top plate section and both of the right and left side wall sections of the fitting stage (2b) so that the lower ends of the drain groove (2c, 2d) are opened downward at the bottom of the case (2).

2. The waterproof housing for the electronic device as claimed in claim 1, wherein in each of the right and left side wall surfaces on the front side of the case (2), the side wall is formed so that the lower part comes ahead of the upper part to thereby make the fitting stage (2b), having the drain groove (2c, 2d) provided along the peripheral surface thereof, formed with the lower part coming ahead of the upper part to be made inclined forward from the vertical direction,

3. The waterproof housing for the electronic device as claimed in claim 1 or 2, wherein the fitting stage (2b) has two drain grooves (2c, 2d) provided along the outer peripheral surface thereof while being aligned in two rows of outer and inner ones.

## Patentansprüche

1. Wasserdichtes Gehäuse für eine elektronische Vorrichtung; wobei das Gehäuse eine Anordnung eines kastenartigen Gehäuses (2) mit einer geöffneten Vorderseite, wobei in dem Gehäuse Schaltungskomponenten montierbar sind, und eine Vorderseitenabdeckung (3) umfasst, die an dem Gehäuse befestigt ist, um das Gehäuse abzudecken, und die Vorderseitenabdeckung an dem Umfang der Vorderseitenöffnung des Gehäuses (2) angebracht ist, um zu verhindern, dass Regenwasser von außerhalb eindringt;
wobei
das Gehäuse (2) eine gewölbte Kopfplatte aufweist,
an der Vorderseite des Gehäuses (2) eine Befestigungsstufe (2b), an der die Vorderseitenabdeckung (3) befestigt ist, gebildet ist, sodass sie von dem Gehäuse entlang dem Umfang der Vorderseitenöffnung des Gehäuses (2) vorsteht, und
die Befestigungsstufe (2b) mindestens eine Ablaufnut (2c, 2d) aufweist, die entlang den Umfangsflächen des Kopfplattenabschnitts und von beiden der rechten und linken Seitenwandabschnitte der Befestigungsstufe (2b) vorgesehen ist, sodass die unteren Enden der Ablaufnut (2c, 2d) nach unten an der Unterseite des Gehäuses (2) geöffnet sind.

2. Wasserdichtes Gehäuse für die elektronische Vorrichtung nach Anspruch 1, wobei in jeder der rechten und linken Seitenwandflächen an der Vorderseite des Gehäuses (2) die Seitenwand derart gebildet ist, dass der untere Teil dem oberen Teil voraus ist, um dadurch die Befestigungsstufe (2b), an der die Ablaufnut (2c, 2d) entlang der Umfangsfläche davon vorgesehen ist, gebildet mit dem unteren Teil dem oberen Teil voraus, der von der vertikalen Richtung nach vorne geneigt herzustellen ist, herzustellen.

3. Wasserdichtes Gehäuse für die elektronische Vorrichtung nach Anspruch 1 oder 2, wobei die Befestigungsstufe (2b) zwei Ablaufnuten (2c, 2d) aufweist, die entlang der äußeren Umfangsfläche davon vorgesehen sind, während sie in zwei Reihen von äußeren und inneren ausgerichtet sind.

## Revendications

1. Boîtier étanche à l'eau pour un dispositif électronique ; le boîtier comprenant un assemblage d'un coffret semblable à une boîte (2) avec un avant ouvert dans lequel des composants de circuit de coffret peuvent être montés et d'un couvercle avant (3) fixé au coffret de manière à recouvrir le coffret, avec le couvercle avant monté sur la périphérie de l'ouverture avant du coffret (2) de manière à empêcher de l'eau de pluie d'entrer depuis l'extérieur,
dans lequel
le coffret (2) a une plaque supérieure arquée,
sur l'avant du coffret (2), un étage de montage (2b), sur lequel le couvercle avant (3) est monté, est formé de manière à faire saillie à partir du coffret le long de la périphérie de l'ouverture avant du coffret (2), et
l'étage de montage (2b) a au moins une rainure de drainage (2c, 2d) fournie le long de surfaces périphériques de la section de plaque supérieure et des deux sections de paroi du côté droit et gauche de l'étage de montage (2b) de sorte que les extrémités inférieures de la rainure de drainage (2c, 2d) sont ouvertes vers le bas au niveau du fond du coffret (2).

2. Boîtier étanche à l'eau pour le dispositif électronique tel que revendiqué par la revendication 1, dans lequel, dans chacune des surfaces de paroi du côté droit et gauche sur le côté avant du coffret (2), la paroi latérale est formée de manière à ce que la partie inférieure est en avant de la partie supérieure pour former ainsi l'étage de montage (2b), ayant la rainure de drainage (2c, 2d) fournie le long de la surface périphérique de celui-ci, formée avec la partie inférieure en avant de la partie supérieure réalisée de manière à être inclinée en avant à partir de la direction verticale.

3. Boîtier étanche à l'eau pour le dispositif électronique tel que revendiqué par la revendication 1 ou 2, dans lequel l'étage de montage (2b) a deux rainures de drainage (2c, 2d) fournies le long de la surface périphérique extérieure de celui-ci tout en étant alignées sur deux rangées d'une extérieure et d'une intérieure.
